# EUROPEAN PATENT APPLICATION

(11) **EP 3 293 238 A1**
(43) Date of publication of application: **14.03.2018**
(21) Application number: 17190251.3
(22) Date of filing: 08.09.2017
(51) Int. Cl.: C09D 11/03, C09D 11/037, C09D 11/101

(54) **INK WITH IMPROVED TRANSFER EFFICIENCY AT LOW TEMPERATURE FOR DIGITAL OFFSET PRINTING APPLICATIONS**

(30) Priority: 12.09.2016 US 201615262750
(71) Applicant: Xerox Corporation, Rochester, NY 14644 (US); Palo Alto Research Center, Incorporated, Palo Alto, CA 94304 (US)
(72) Inventor: MAYO, James D., Mississauga, Ontario, L4Y 1V1 (CA); MAGDALINIS, Aurelian Valeriu, Newmarket, Ontario, L3X 2X3 (CA); STOWE, Timothy D., Alameda, CA California 94501 (US); ALLEN, C. Geoffrey, Waterdown, Ontario, Ontario L0R 2H5 (CA); ABRAHAM, Biby E., Mississauga, Ontario L5M 7E2 (CA); BRETON, Marcel P., Mississauga, Ontario, L5K 2S6 (CA); LEE, Jonathan Siu-Chung, Oakville, Ontario L6H 4K4 (CA)
(74) Representative: BRP Renaud & Partner mbB Rechtsanwälte Patentanwälte Steuerberater

(57) **Abstract**

An ink composition useful for digital offset printing applications includes a colorant and a high viscosity thickening agent. A process for variable data lithographic printing includes applying a dampening fluid to an imaging member surface; forming a latent image by evaporating the dampening fluid from selective locations on the imaging member surface to form hydrophobic non-image areas and hydrophilic image areas; developing the latent image by applying an ink composition comprising an ink component to the hydrophilic image areas, the ink composition comprising a high viscosity thickening agent to raise the viscosity of the composition from about 1.05 to about 2 times higher while maintaining excellent transfer to a substrate at low temperatures.

## Description

### BACKGROUND OF THE INVENTION

Disclosed herein are certain ink compositions which are compatible with dampening fluids and are useful for variable data lithographic printing. This disclosure also relates to methods of using such ink compositions, such as in variable lithographic printing applications.

Conventional lithographic printing techniques cannot accommodate true high-speed variable data printing processes in which images to be printed change from impression to impression, for example, as enabled by digital printing systems. The lithography process is often relied upon, however, because it provides very high quality printing due to the quality and color gamut of the inks used. Lithographic inks are also less expensive than other inks, toners, and many other types of printing or marking materials.

Ink-based digital printing uses a variable data lithography printing system, or digital offset printing system, or a digital advanced lithography imaging system. A "variable data lithography system" is a system that is configured for lithographic printing using lithographic inks and based on digital image data, which may be variable from one image to the next. "Variable data lithography printing," or "digital ink-based printing," or "digital offset printing," or digital advanced lithography imaging is lithographic printing of variable image data for producing images on a substrate that are changeable with each subsequent rendering of an image on the substrate in an image forming process.

For example, a digital offset printing process may include transferring radiation-curable ink onto a portion of a fluorosilicone-containing imaging member or printing plate that has been selectively coated with a dampening fluid layer according to variable image data. Regions of the dampening fluid are removed by exposure to a focused radiation source (e.g., a laser light source) to form pockets. A temporary pattern in the dampening fluid is thereby formed over the printing plate. Ink applied thereover is retained in the pockets formed by the removal of the dampening fluid. The inked surface is then brought into contact with a substrate and the ink transfers from the pockets in the dampening fluid layer to the substrate. The dampening fluid may then be removed, a new uniform layer of dampening fluid applied to the printing plate, and the process repeated. The ink is then transferred from the printing plate to a substrate such as paper, plastic, or metal on which an image is being printed and cured. The same portion of the imaging plate may be optionally cleaned depending on ink type and used to make a succeeding image that is different than the preceding image, based on the variable image data.

Digital offset printing inks differ from conventional inks because they must meet demanding rheological requirements imposed by the lithographic printing process while being compatible with system component materials and meeting the functional requirements of subsystem components, including wetting and transfer. Print process studies have demonstrated that high viscosity inks are preferred for ink transfer to the printing plate and subsequently to the substrate. The use of a temperature differential between the printing plate and substrate has resulted in a significant improvement in ink transfer efficiency, but this demands that still higher viscosity inks be used. Addition of high molecular weight ink components to thicken inks can lead to instability as the materials precipitate from the ink, and can also result in compromised image quality and curing efficiency.

### BRIEF SUMMARY OF THE INVENTION

According to aspects of the embodiments, the present disclosure relates to certain ink compositions which are compatible with dampening fluids and are useful for variable data lithographic printing. The ink composition includes a colorant and a high viscosity thickening agent. A process for variable data lithographic printing includes applying a dampening fluid to an imaging member surface; forming a latent image by evaporating the dampening fluid from selective locations on the imaging member surface to form hydrophobic non-image areas and hydrophilic image areas; developing the latent image by applying an ink composition comprising an ink component to the hydrophilic image areas, the ink composition comprising a high viscosity thickening agent to raise the viscosity of the composition from about 1.05 to about 2 times higher while maintaining excellent transfer to a substrate at low temperatures.

### BRIEF DESCRIPTION OF THE DRAWINGS

FIG. 1 illustrates a block diagram of a system that shows a related art ink-based digital printing system in which the ink compositions of the present disclosure may be used;
FIG. 2 is a plot showing the rheology characteristics of cyan ink measured at 35°C in accordance to an embodiment;
FIG. 3 is a plot showing the rheology characteristics of magenta ink measured at 35°C in accordance to an embodiment;
FIG. 4 is a plot showing the rheology characteristics of yellow ink measured at 35°C in accordance to an embodiment; and
FIG. 5 is a plot showing the rheology characteristics of black ink measured at 35°C in accordance to an embodiment.

### DETAILED DESCRIPTION OF THE INVENTION

Exemplary embodiments are intended to cover all alternatives, modifications, and equivalents as may be included within the spirit and scope of the composition, apparatus and systems as described herein.

A more complete understanding of the processes and apparatuses disclosed herein can be obtained by reference to the accompanying drawings. These figures are merely schematic representations based on convenience and the ease of demonstrating the existing art and/or the present development, and are, therefore, not intended to indicate relative size and dimensions of the assemblies or components thereof. In the drawing, like reference numerals are used throughout to designate similar or identical elements.

Example 1 includes an ink composition for variable data lithography printing comprising an ink vehicle and at least one colorant component suspended in solution in the ink composition; and the solution comprising two or more of at least one dispersant; a thermal stabilizer; and a photo initiator system; wherein a viscosity of the ink composition for variable lithography printing, after addition of a high viscosity thickening agent component to the ink composition, is from about 1.05 to about 2 times higher than the viscosity before the addition of a high viscosity thickening agent to the ink composition.

Example 2 includes example 1 and further comprising a rheology modifying agent.

Example 3 includes example 2 and wherein the vehicle is a radiation-curable compound that comprises monomer compounds selected from the group of compounds comprising mono-, di-, and tri-functional acrylate monomers, tetra-functional acrylates and oligomers.

Example 4 includes example 3 and wherein the radiation-curable water-dilutable compound comprises functional acrylate compounds.

Example 5 includes example 3 and wherein the at least one colorant component comprises a pigment, the pigment component is in a proportion of at least 15% by weight.

Example 6 includes example 5 and wherein the thickening agent component being in a range of 9% or less by weight in the solution.

Example 7 includes example 5 and the thickening agent component is present in the ink composition in a range of about 1 weight percent to about 10 weight percent.

Example 8 includes example 7 and the rheology modifying is present in the ink composition in a range of about 1 weight percent to about 10 weight percent.

Example 9 includes example 8 and wherein the ink composition has a viscosity of greater than 200,000 centipoise (cps) at 35°C.

Example 10 includes example 9 and wherein the ink composition has a viscosity of greater than 200,000 cps at 100 rad/sec.

Example 11 includes example 9 and wherein lowering certain low viscosity components in the ink composition a percent by weight increases the viscosity of the ink composition.

Example 12 includes a process for variable lithographic printing, comprising applying a dampening fluid to an imaging member surface; forming a latent image by evaporating the dampening fluid from selective locations on the imaging member surface to form hydrophobic non-image areas and hydrophilic image areas; developing the latent image by applying an ink composition comprising an ink component to the hydrophilic image areas; and transferring the developed latent image to a receiving substrate; wherein the ink composition comprises an ink vehicle and at least one colorant component suspended in solution in the ink composition; and the solution comprising two or more of at least one dispersant; a thermal stabilizer; and a photo initiator system; wherein a viscosity of the ink composition for variable lithography printing, after addition of a high viscosity thickening agent component to the ink composition, is from about 1.05 to about 2 times higher than the viscosity before the addition of a high viscosity thickening agent to the ink composition; wherein colorant components s have viscosities within 5% of each other at 100 rad/sec and between 5 × 10⁵ and 1 × 10⁷ cps at 1 rad/sec.

Example 13 includes example 12 and where the solution further comprises a rheology modifying agent and wherein the rheology modifying agent is present in the ink composition in a range of about 1 weight percent to about 10 weight percent.

Although specific terms are used in the following description for the sake of clarity, these terms are intended to refer only to the particular structure of the embodiments selected for illustration in the drawings, and are not intended to define or limit the scope of the disclosure. In the drawings and the following description below, it is to be understood that like numeric designations refer to components of like function.

The modifier "about" used in connection with a quantity is inclusive of the stated value and has the meaning dictated by the context (for example, it includes at least the degree of error associated with the measurement of the particular quantity). When used with a specific value, it should also be considered as disclosing that value. For example, the term "about 2" also discloses the value "2" and the range "from about 2 to about 4" also discloses the range "from 2 to 4."

Although embodiments of the invention are not limited in this regard, the terms "plurality" and "a plurality" as used herein may include, for example, "multiple" or "two or more". The terms "plurality" or "a plurality" may be used throughout the specification to describe two or more components, devices, elements, units, parameters, or the like. For example, "a plurality of stations" may include two or more stations. The terms "first," "second," and the like, herein do not denote any order, quantity, or importance, but rather are used to distinguish one element from another. The terms "a" and "an" herein do not denote a limitation of quantity, but rather denote the presence of at least one of the referenced item.

The term "printing device" or "printing system" as used herein refers to a digital copier or printer, scanner, image printing machine, digital production press, document processing system, image reproduction machine, bookmaking machine, facsimile machine, multi-function machine, or the like and can include several marking engines, feed mechanism, scanning assembly as well as other print media processing units, such as paper feeders, finishers, and the like. The printing system can handle sheets, webs, marking materials, and the like. A printing system can place marks on any surface, and the like and is any machine that reads marks on input sheets; or any combination of such machines.

The term "print media" generally refers to a usually flexible, sometimes curled, physical sheet of paper, substrate, plastic, or other suitable physical print media substrate for images, whether precut or web fed.

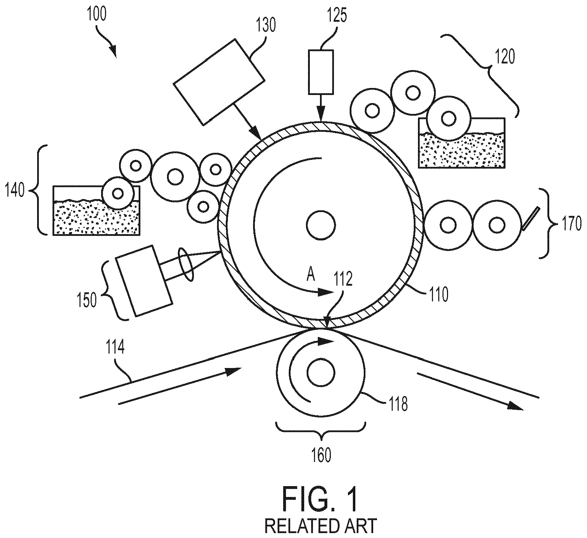

As shown in FIG. 1, the exemplary system 100 may include an imaging member 110. System 100 illustrates a system for variable lithography in which the ink compositions of the present disclosure may be used. The imaging member 110 in the embodiment shown in FIG. 1 is a drum, but this exemplary depiction should not be interpreted so as to exclude embodiments wherein the imaging member 110 includes a drum, plate or a belt, or another now known or later developed configuration. The reimageable surface may be formed of materials including, for example, a class of materials commonly referred to as silicones, including polydimethylsiloxane (PDMS), among others. For example, silicone, fluorosilicone, and/or VITON may be used. The reimageable surface may be formed of a relatively thin layer over a mounting layer, a thickness of the relatively thin layer being selected to balance printing or marking performance, durability and manufacturability.

The imaging member 110 is used to apply an ink image to an image receiving media substrate 114 at a transfer nip 112. The transfer nip 112 is formed by an impression roller 118, as part of an image transfer mechanism 160, exerting pressure in the direction of the imaging member 110. Image receiving medium substrate 114 should not be considered to be limited to any particular composition such as, for example, paper, plastic, or composite sheet film. The exemplary system 100 may be used for producing images on a wide variety of image receiving media substrates. There is wide latitude of marking (printing) materials that may be used, including marking materials with pigment loading greater than 10% by weight. This disclosure will use the term ink to refer to a broad range of printing or marking materials to include those which are commonly understood to be inks, pigments, and other materials which may be applied by the exemplary system 100 to produce an output image on the image receiving media substrate 114.

The imaging member 110 including the imaging member 110 being comprised of a reimageable surface layer formed over a structural mounting layer that may be, for example, a cylindrical core, or one or more structural layers over a cylindrical core.

The exemplary system 100 includes a dampening fluid system 120 generally comprising a series of rollers, which may be considered as dampening rollers or a dampening unit, for uniformly wetting the reimageable surface of the imaging member 110 with dampening fluid. A purpose of the dampening fluid system 120 is to deliver a layer of dampening fluid, generally having a uniform and controlled thickness, to the reimageable surface of the imaging member 110. As indicated above, it is known that a dampening fluid such as fountain solution may comprise mainly water optionally with small amounts of isopropyl alcohol or ethanol added to reduce surface tension as well as to lower evaporation energy necessary to support subsequent laser patterning, as will be described in greater detail below. Small amounts of certain surfactants may be added to the fountain solution as well. Alternatively, other suitable dampening fluids may be used to enhance the performance of ink based digital lithography systems. Exemplary dampening fluids include water, NOVEC® 7600 (1,1,1,2,3,3-Hexafluoro-4-(1,1,2,3,3,3-hexafluoropropoxy)pentane and has CAS#870778-34-0), and D4 (octamethylcyclotetrasiloxane).

Once the dampening fluid is metered onto the reimageable surface of the imaging member 110, a thickness of the dampening fluid may be measured using a sensor 125 that may provide feedback to control the metering of the dampening fluid onto the reimageable surface of the imaging member 110 by the dampening fluid system 120.

After a precise and uniform amount of dampening fluid is provided by the dampening fluid system 120 on the reimageable surface of the imaging member 110, and optical patterning subsystem 130 may be used to selectively form a latent image in the uniform dampening fluid layer by image-wise patterning the dampening fluid layer using, for example, laser energy. Typically, the dampening fluid will not absorb the optical energy (IR or visible) efficiently. The reimageable surface of the imaging member 110 should ideally absorb most of the laser energy (visible or invisible such as IR) emitted from the optical patterning subsystem 130 close to the surface to minimize energy wasted in heating the dampening fluid and to minimize lateral spreading of heat in order to maintain a high spatial resolution capability. Alternatively, an appropriate radiation sensitive component may be added to the dampening fluid to aid in the absorption of the incident radiant laser energy. While the optical patterning subsystem 130 is described above as being a laser emitter, it should be understood that a variety of different systems may be used to deliver the optical energy to pattern the dampening fluid.

The mechanics at work in the patterning process undertaken by the optical patterning subsystem 130 of the exemplary system 100 are known to those in the art. Briefly, the application of optical patterning energy from the optical patterning subsystem 130 results in selective removal of portions of the layer of dampening fluid.

Following patterning of the dampening fluid layer by the optical patterning subsystem 130, the patterned layer over the reimageable surface of the imaging member 110 is presented to an inker subsystem 140. The inker subsystem 140 is used to apply a uniform layer of ink over the layer of dampening fluid and the reimageable surface layer of the imaging member 110. The inker unit 140 further comprises heated ink baths whose temperatures are regulated by temperature control module. The inker subsystem 140 may use an anilox roller to meter an offset lithographic ink onto one or more ink forming rollers that are in contact with the reimageable surface layer of the imaging member 110. Separately, the inker subsystem 140 may include other traditional elements such as a series of metering rollers to provide a precise feed rate of ink to the reimageable surface. The inker subsystem 140 may deposit the ink to the pockets representing the imaged portions of the reimageable surface, while ink on the unformatted portions of the dampening fluid will not adhere to those portions.

The cohesiveness and viscosity of the ink residing in the reimageable layer of the imaging member 110 may be modified by a number of mechanisms. One such mechanism may involve the use of a rheology (complex viscoelastic modulus) control subsystem 150. The rheology control system 150 may form a partial crosslinking core of the ink on the reimageable surface to, for example, increase ink cohesive strength relative to the reimageable surface layer. Curing mechanisms may include optical or photo curing, heat curing, drying, or various forms of chemical curing. Cooling may be used to modify rheology as well via multiple physical cooling mechanisms, as well as via chemical cooling.

The ink is then transferred from the reimageable surface of the imaging member 110 to a substrate of image receiving medium 114 using a transfer subsystem 160. The transfer occurs as the substrate 114 is passed through a nip 112 between the imaging member 110 and an impression roller 118 such that the ink within the voids of the reimageable surface of the imaging member 110 is brought into physical contact with the substrate 114. With the adhesion of the ink having been modified by the rheology control system 150, modified adhesion of the ink causes the ink to adhere to the substrate 114 and to separate from the reimageable surface of the imaging member 110. Careful control of the temperature and pressure conditions at the transfer nip 112 may allow transfer efficiencies for the ink from the reimageable surface of the imaging member 110 to the substrate 114 to exceed 95%. While it is possible that some dampening fluid may also wet substrate 114, the volume of such a dampening fluid will be minimal, and will rapidly evaporate or be absorbed by the substrate 114.

In certain offset lithographic systems, it should be recognized that an offset roller, not shown in FIG. 1, may first receive the ink image pattern and then transfer the ink image pattern to a substrate according to a known indirect transfer method. Following the transfer of the majority of the ink to the substrate 114, any residual ink and/or residual dampening fluid must be removed from the reimageable surface of the imaging member 110, preferably without scraping or wearing that surface. An air knife may be employed to remove residual dampening fluid. It is anticipated, however, that some amount of ink residue may remain. Removal of such remaining ink residue may be accomplished through use of some form of cleaning subsystem 170. The cleaning subsystem 170 comprises at least a first cleaning member such as a sticky or tacky member in physical contact with the reimageable surface of the imaging member 110, the sticky or tacky member removing residual ink and any remaining small amounts of surfactant compounds from the dampening fluid of the reimageable surface of the imaging member 110. The sticky or tacky member may then be brought into contact with a smooth roller to which residual ink may be transferred from the sticky or tacky member, the ink being subsequently stripped from the smooth roller by, for example, and a doctor blade.

Other mechanisms by which cleaning of the reimageable surface of the imaging member 110 may be facilitated. Regardless of the cleaning mechanism, however, cleaning of the residual ink and dampening fluid from the reimageable surface of the imaging member 110 is essential to preventing ghosting in the proposed system. Once cleaned, the reimageable surface of the imaging member 110 is again presented to the dampening fluid system 120 by which a fresh layer of dampening fluid is supplied to the reimageable surface of the imaging member 110, and the process is repeated.

As discussed above, digital offset ink must possess physical and chemical properties that are specific to ink-based digital printing systems. The ink must be compatible with materials that it comes in contact with, including the imaging plate and dampening fluid, and printable substrates such as paper, metal, or plastic. The ink must also meet all functional requirements of the subsystems including wetting and transfer properties defined by subsystem architecture and material sets.

Inks formulated for ink-based digital printing, or digital offset inks, are different in many ways from other inks developed for printing applications, including pigmented solvents, UV gel inks, and other inks. For example, digital offset inks contain much higher pigment and therefore have higher viscosity at room temperature than other inks, which can make ink delivery by way of an anilox roll or inkjet system difficult. Digital offset inks must meet certain wetting and release property requirements imposed by the imaging member used for ink-based digital printing processes, while being compatible with non-aqueous dampening fluid options. Digital offset ink should not cause the imaging member surface to swell. Water-dilutable and water-diluted inks in accordance with embodiments include digital offset acrylate inks meeting such requirements.

Digital offset inks in accordance with water-dilutable ink embodiments advantageously have a much lower solubility in dampening fluid such as D4 than related art inks. Also, digital offset inks of embodiments do not tend to swell a silicone-containing imaging member surface layer used in ink-based digital printing systems such as that shown in FIG. 1, which may be a silicone, fluorosilicone, or VITON-containing imaging plate or blanket.

The ink must be compatible with materials it is in contact with, including printing plate 110, fountain solution applied by dampening fluid system 120, and other cured or non-cured inks. It must also meet all functional requirements of the sub-systems, including wetting and transfer properties. Transfer of the imaged inks is challenging, as the ink must at once wet the blanket material homogeneously (plate 110), and transfer from the blanket to the substrate (112, 114, and 118). Transfer of the image layer must be very efficient, at least as high as 90%, as the cleaning sub-station can only eliminate small amounts of residual ink. Any ink remaining on the blanket after cleaning would result in an unacceptable ghost image appearing in subsequent prints. Not surprisingly, ink rheology plays a key role in the transfer characteristics of an ink.

Partial cure of the ink on the blanket (see UV source 150 at FIG. 1) was investigated in the past as a way to control the ink rheology prior to transfer to substrate. While this approach did work reasonably well, the robustness of the process and impact on the blanket life limited its application. An alternative approach was proposed which involved delivering the inks at high temperature (T) and then cooling down the ink layer on the imaging cylinder before transfer. A number of experiments were conducted with inks having different rheological characteristics at high and low T and also at high (100 rad/s) and low shear rates (1 rad/s). A range of low and high temperatures were explored in order to identify optimum conditions for transfer at high speed (1 m/s). It was found that both the temperature and temperature difference between the blanket and the substrate is an important variable with respect to image transfer. Heating of the inker unit to 60 - 70°C, coupled with cooling of the central imaging cylinder to 15 - 20°C results in very efficient ink delivery and image transfer with little or no residual ink remaining on the blanket. However, heated inker unit resulted in the need for higher viscosity inks than what had been used previously, going from viscosity (η) around 100,000 cps to over 200,000 cps, as measured at 35°C at a shear rate of 100 rad/sec.

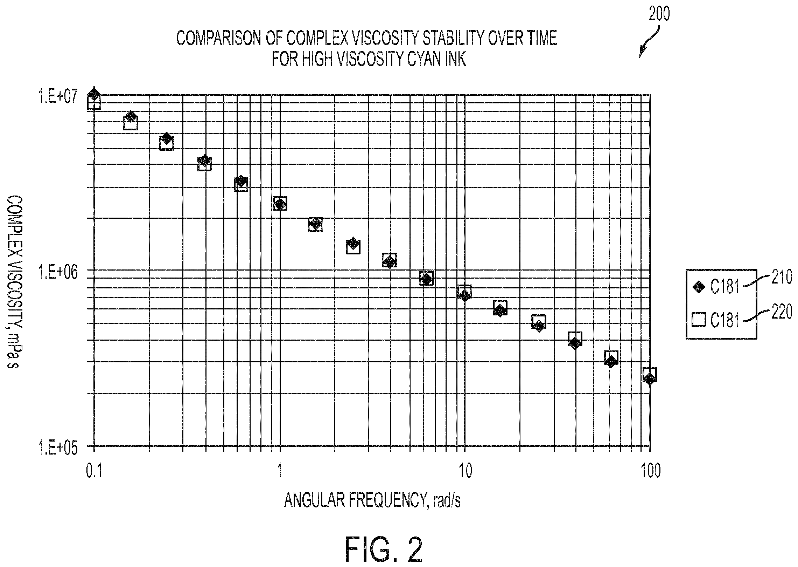

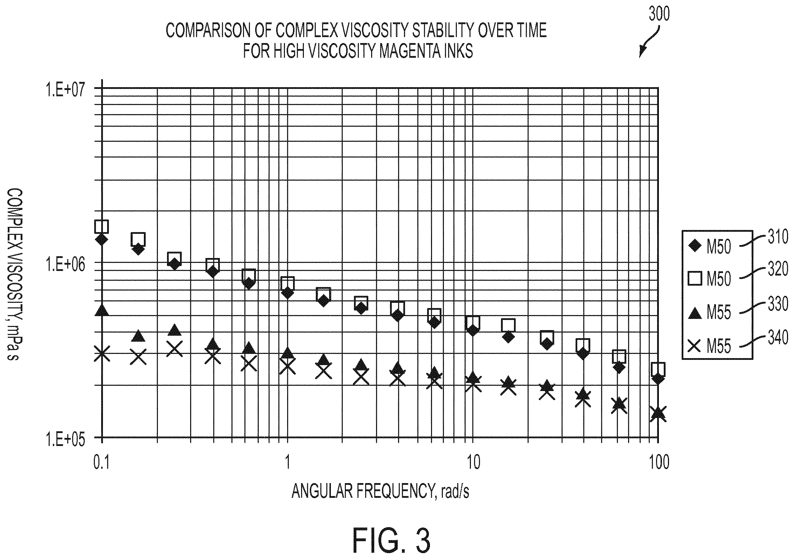

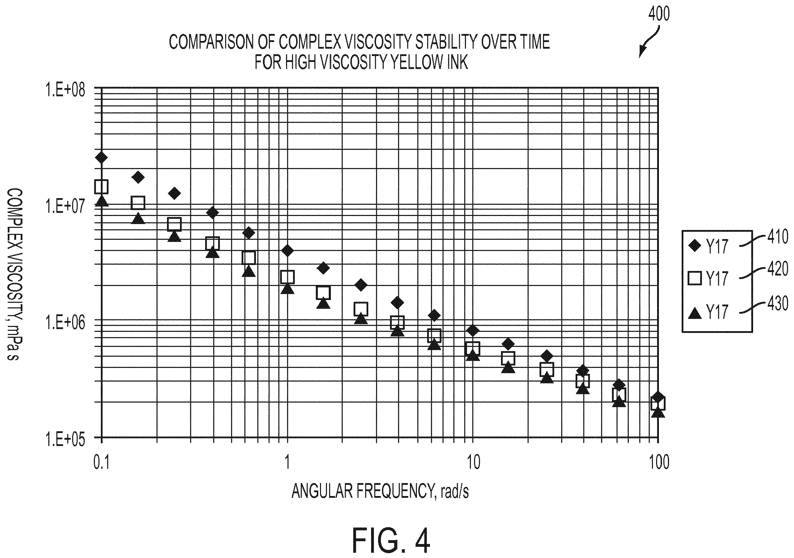

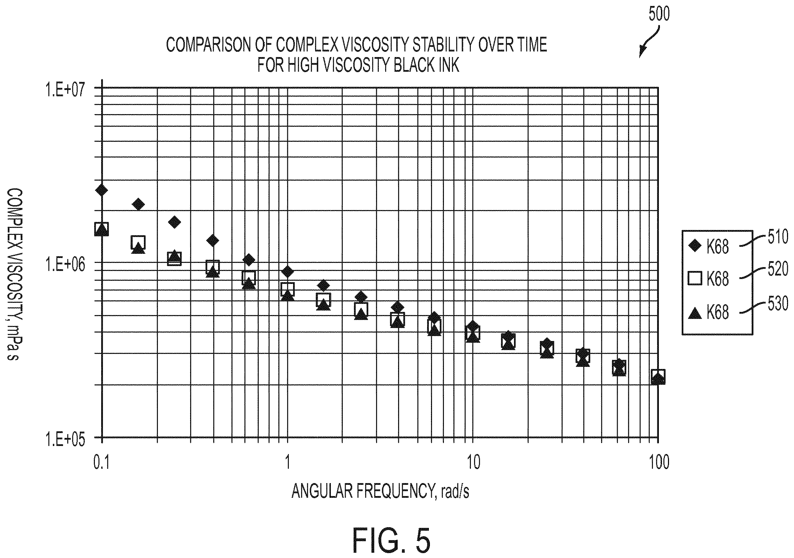

The new ink requirements can be attained either by reduction or removal of low viscosity components in the ink, for example, the monomer SR501 or the UV stabilizer CN3216, or with the addition of a high viscosity thickening agent. Claytone HY and/or CN2256 can be used as a thickening agent. CN2256 has the advantage of being a curable resin, while the clay is an inert material. The use of CN2256 in the ink will therefore not compromise the curing efficiency of the printed image. However, as stated above, each component can have multiple purposes, thus, it may be desirable to have a mixture of clay and CN2256 to achieve optimum rheological or image transfer characteristics. The low viscosity components in these inks serve other purposes, such as ink compatibility with other ink components and/or sub-systems (e.g., imaging plate and the like.), as well as curing efficiency, thus their removal could be detrimental to overall ink performance. Addition of a high molecular weight thickening agent can dramatically increase ink viscosity, but can also result in destabilization of the ink, as this new material can potentially precipitate or cause phase separation in the ink. The material CN2256, a solid oligomeric acrylate available from Sartomer Inc., has been used in this capacity. We have formulated a stable digital advanced lithography imaging ink set having significant amounts of CN2256, which undergoes excellent image transfer at 60°C. Optimization of the four colored ink formulations (Table 1) afforded inks having very similar rheological characteristics, which are stable after several months aging. The stability over time is shown in FIG.2 for Cyan Ink 200, 2 days 210, 86 days 220; FIG. 3 for Magenta Inks 300, 1 day 310, 55 days 320, 1 day 330, 27 days 340; FIG. 4 for Yellow Ink 400, 1 day 410, 30 days 420, 62 days 430; and, FIG. 5 for Black ink 500, 1 day 510, 37 days 520, 83 days 530. The yellow sample (400) appears to be somewhat unstable over time, but this can possibly be attributed to there being very little sample remaining for the aged measurement.

The ink formulation shown in Table 1 meets the higher viscosity needed in variable lithography system or digital advanced lithography imaging systems. The inks described herein may include the following components: (a) radiation-curable water-dilutable monomer compounds, including mono-, di-, and tri-functional water-dilutable acrylate monomers, oligomers; (b) dispersants; (c) pigments; (d) clays or additives; (e) initiators; (f) additional curable compounds including monomers, oligomers, including oligomers from Sartomer USA, LLC or Cytec Industries, Inc., prepolymers, polymers; (g) additives including surfactants, free-radical scavengers, and the like; (h) thermal stabilizers.

The water-diluted curable components may include any water-dilutable acrylate or methacrylate monomer compound(s) suitable for use as a phase change ink carrier or ink vehicle that may be water dilutable, with an addition of water being available to adjust and/or enhance background performance for use in the variable digital data lithographic printing architecture. In embodiments, the water-diluted curable component is a water-dilutable functional acrylate monomer, a methacrylate monomer, a multifunctional acrylate monomer, a multifunctional methacrylate monomer, or a mixture or combination thereof. Exemplary acrylates may include acrylate monomers or polymers such as polyester acrylates Sartomer CN294E, Sartomer CD-501, Sartomer CN9014, Sartomer CN2282 and Sartomer CN2256. In embodiments, a mixture of the components is water-dilutable.

Examples of curable monomers and diluting acrylates which can be used in the ink compositions as vehicles may include Trimethylolpropane triacrylate; SR-492, SR-501, SR-444, SR-454, SR-499, SR-502, SR-9035 and SR-415 from Sartomer; EBECRYL 853 and EBECRYL 5500 from Allnex. Trimethylolpropane triacrylate has a refractive index of 1.474, a specific gravity of 1.06 g/cm³, an APHA Color of less than 300 and a viscosity range of 80 to 120 cps at 25°C. Sartomer SR-492 is a three mole propoxylated trimethylolpropane triacrylate and has a refractive index of 1.459, a specific gravity of 1.05 g/cm³, a Tg of -15°C, an APHA Color of 30 and a viscosity of 90 cps at 25°C. Sartomer SR-501 is a six mole propoxylated trimethylolpropane triacrylate and has a refractive index of 1.4567, a specific gravity of 1.048 g/cm³, a Tg of -2°C, an APHA Color of 90 and a viscosity of 125 cps at 25°C. Sartomer SR-444 is a pentaerythritol triacrylate and has a refractive index of 1.4801, a specific gravity of 1.162 g/cm³, a Tg of 103°C, an APHA Color of 50 and a viscosity of 520 cps at 25°C. Sartomer SR-454 is a three mole ethoxylated trimethylolpropane triacrylate and has a refractive index of 1.4689, a specific gravity of 1.103 g/cm³, a Tg of 120°C, an APHA Color of 55 and a viscosity of 60 cps at 25°C. Sartomer SR-499 is a six mole ethoxylated trimethylolpropane triacrylate and has a refractive index of 1.4691, a specific gravity of 1.106 g/cm³, a Tg of -8°C, an APHA Color of 50 and a viscosity of 85 cps at 25°C. Sartomer SR-502 is a nine mole ethoxylated trimethylolpropane triacrylate and has a refractive index of 1.4691, a specific gravity of 1.11 g/cm³, a Tg of -19°C, an APHA Color of 140 and a viscosity of 130 cps at 25°C. Sartomer SR-9035 is a fifteen mole ethoxylated trimethylolpropane triacrylate and has a refractive index of 1.4695, a specific gravity of 1.113 g/cm³, a Tg of -32°C, an APHA Color of 60 and a viscosity of 168 cps at 25°C. Sartomer SR-415 is a twenty mole ethoxylated trimethylolpropane triacrylate and has a refractive index of 1.4699, a specific gravity of 1.115 g/cm³, a Tg of -40°C, an APHA Color of 55 and a viscosity of 225 cps at 25°C. EBECRYL 853 is a low viscosity polyester triacrylate and has a specific gravity of 1.10 g/cm³, an APHA Color of 200 and a viscosity of 80 cps at 25°C. EBECRYL 5500 is a low viscosity glycerol derivative triacrylate and has a specific gravity of 1.07 g/cm³, an APHA Color of 62 and a viscosity of 130 cps at 25°C. Other triacrylate, monoacrylate, diacrylate, tetraacrylate and higher functional acrylate monomers, diluting acrylates, and various combinations thereof, can also be used in the ink compositions as vehicles.

The monomer or oligomer can be present in any suitable amount. In embodiments, the monomer or oligomer, or combination thereof is added in an amount of from about 10 to about 85%, or from about 30 to about 80%, or from about 50 to about 70%, by weight based on the total weight of the curable ink composition. Curable oligomers which can be used in the ink compositions as vehicles may include Sartomer CN294E; CN2256; CN2282; CN9014 and CN309. Sartomer CN294E is a tetrafunctional acrylated polyester oligomer. CN294E is a clear liquid having a specific gravity of 0.93 and a viscosity of 4,000 cps at 60°C. Sartomer CN2256 is a di-functional polyester acrylate oligomer and has a refractive index of 1.5062, a Tg of -22°C, a tensile strength of 675 psi, and a viscosity of 11,000 cps at 60°C.

Sartomer CN2282 is a tetrafunctional acrylated polyester and is a clear liquid having a specific gravity of 1.15 and a viscosity of 2,500 cps at 60°C. Sartomer CN9014 is a difunctional acrylated urethane and is a non-clear liquid having a specific gravity of 0.93 and a viscosity of 19,000 cps at 60°C. Sartomer CN309 is an oligomer containing an acrylate ester that derives from an aliphatic hydrophobic backbone, or in other words is an aliphatic acrylate ester. CN309 is a clear liquid having a specific gravity of 0.92, a density of 7.68 pounds/gallon, a surface tension of 26.3 dynes/cm, a viscosity of 150 cps at 25°C, and a viscosity of 40 cps at 60°C.

Examples of curable oligomers which can be used in the ink compositions as vehicles may include CN294E, CN2256, CN2282, CN9014 and CN309 from Sartomer; EBECRYL 8405, EBECRYL 8411, EBECRYL 8413, EBECRYL 8465, EBECRYL 8701, EBECRYL 9260, EBECRYL 546, EBECRYL 657, EBECRYL 809, and the like from Allnex. EBECRYL 8405 is a tetrafunctional urethane acrylate diluted as 80 weight percent (wt%) by weight in 1,6-Hexanediol diacrylate (HDDA). EBECRYL 8405 is a clear liquid having a Gardner Color of 2 and a viscosity of 4,000 cps at 60°C. EBECRYL 8411 is a difunctional urethane acrylate diluted as 80 wt% by weight in isobornylacrylate (IBOA). EBECRYL 8411 is a clear liquid having a viscosity range of 3,400 to 9,500 cps at 65°C. EBECRYL 8413 is a difunctional urethane acrylate diluted as 67 wt% by weight in IBOA. EBECRYL 8413 is a clear liquid having a viscosity of 35,000 cps at 60°C. EBECRYL 8465 is a trifunctional urethane acrylate. EBECRYL 8465 is a clear liquid having a Gardner Color of 2 and a viscosity of 21,000 cps at 60°C. EBECRYL 8701 is a trifunctional urethane acrylate. EBECRYL 8701 is a clear liquid having a Gardner Color of 2 and a viscosity of 4,500 cps at 60°C. EBECRYL 9260 is a trifunctional urethane acrylate. EBECRYL 9260 is a clear liquid having a Gardner Color of 2 and a viscosity of 4,000 cps at 60°C. EBECRYL 546 is a trifunctional polyester acrylate. EBECRYL 546 is a clear liquid having a Gardner Color of 1.5 and a viscosity of 350,000 cps at 25°C. EBECRYL 657 is a tetrafunctional polyester acrylate. EBECRYL 657 is a clear liquid having a Gardner Color of 4 and a viscosity of 125,000 cps at 25°C. EBECRYL 809 is a trifunctional polyester acrylate. EBECRYL 809 is a clear liquid having a Gardner Color of 3 and a viscosity of 1,300 cps at 60°C.

The dispersant components may include any suitable or desired dispersant including, but not limited to AB-diblock copolymers of high molecular weight such as EFKA® 4340 available from BASF SE, and DISPERBYK® 2100 available from Byk-Chemie GmbH, or a mixture thereof. In a specific embodiment, the dispersant mixture comprises a cyclohexane dimethanol diacrylate (such as CD406® available from Sartomer USA, LLC) and at least one additional component, such as EFKA® 4340 is a high molecular weight dispersing agent having an AB-diblock copolymer structure available from BASF SE. In an exemplary embodiment, the dispersant is a polymeric dispersant, such as SOLSPERSE® 39000, commercially available from The Lubrizol Corporation. The dispersant may be added in an amount within the range of from about 20% to about 100% by weight, based on the weight of the composition. Dispersant may be added in an amount that is determined based on the amount of pigment used.

The disclosed curable ink composition also includes a colorant or pigment component, which may be any desired or effective colorant may be employed, including pigments, mixtures of pigments, mixtures of pigments and dyes, and the like, provided that the colorant may be dissolved or dispersed in the at least one monomer and at least one dispersant. In specific embodiments, the colorant is a pigment. Examples of suitable pigments include PALIOGEN Violet 5100 (BASF); PALIOGEN Violet 5890 (BASF); HELIOGEN Green L8730 (BASF); LITHOL Scarlet D3700 (BASF); SUNFAST Blue 15:4 (Sun Chemical); Hostaperm Blue B2G-D (Clariant); Permanent Red P-F7RK; HOSTAPERM Violet BL (Clariant); LITHOL Scarlet 4440 (BASF); Bon Red C (Dominion Color Company); ORACET Pink RF (Ciba); PALIOGEN Red 3871 K (BASF); SUNFAST Blue 15:3 (Sun Chemical); PALIOGEN Red 3340 (BASF); SUNFAST Carbazole Violet 23 (Sun Chemical); LITHOL Fast Scarlet L4300 (BASF); SUNBRITE Yellow 17 (Sun Chemical); HELIOGEN Blue L6900, L7020 (BASF); SUNBRITE Yellow 74 (Sun Chemical); SPECTRA PAC C Orange 16 (Sun Chemical); HELIOGEN Blue K6902, K6910 (BASF); SUNFAST Magenta 122 (Sun Chemical); HELIOGEN Blue D6840, D7080 (BASF); Sudan Blue OS (BASF); NEOPEN Blue FF4012 (BASF); PV Fast Blue B2GO1 (Clariant); IRGALITE Blue BCA (Ciba); PALIOGEN Blue 6470 (BASF); Sudan Orange G (Aldrich), Sudan Orange 220 (BASF); PALIOGEN Orange 3040 (BASF); PALIOGEN Yellow 152, 1560 (BASF); LITHOL Fast Yellow 0991 K (BASF); PALIOTOL Yellow 1840 (BASF); NOVOPERM Yellow FGL (Clariant); Lumogen Yellow D0790 (BASF); Suco-Yellow L1250 (BASF); Suco-Yellow D1355 (BASF); Suco Fast Yellow D1355, D1351 (BASF); HOSTAPERM Pink E 02 (Clariant); Hansa Brilliant Yellow 5GX03 (Clariant); Permanent Yellow GRL 02 (Clariant); Permanent Rubine L6B 05 (Clariant); FANAL Pink D4830 (BASF); CINQUASIA Magenta (DuPont); PALIOGEN Black L0084 (BASF); Pigment Black K801 (BASF); and carbon blacks such as REGAL 330® (Cabot), Carbon Black 5250, Carbon Black 5750 (Columbia Chemical), and the like, as well as mixtures thereof.

The disclosed curable ink composition also includes a thermal stabilizer, an exemplary thermal stabilizer is Sartomer CN3216, which is an acrylate stabilizing additive having a specific gravity of 1.113 at 25°C and a viscosity of 1,100 cps at 25°C. Another exemplary thermal stabilizer is IRGASTAB UV 10, available from Ciba Specialty Chemicals, which acts as a radical scavenger to prevent thermal curing of UV curable components. The thermal stabilizer(s) may be present in an amount of from about 0.1 to about 1 wt % of the ink composition.

In an exemplary embodiment, a digital offset ink composition may include a cyan pigment, Ciba IRGALITE Blue GOL, originally available from BASF HELIOGEN Blue D 7088. The amount of colorant or pigment added to the ink composition may be within the range of from about 10% to about 30% by weight of the composition, or from about 19% to about 25%, or from about 20% or more, up to about 30%, based on the total weight of the ink composition.

In some embodiments, the acrylate ink compositions may include rheology modifiers. Exemplary rheology modifiers may be modified or unmodified inorganic compounds including organoclays, attapulgite clays and bentonite clays, including tetraallkyl ammonium bentonites as well as treated and untreated synthetic silicas. Suitable organoclays include from Southern Clay Products CLAYTONE HA and CLAYTONE HY. Suitable examples of tetraallkyl ammonium bentonites include from Celeritas Chemicals CELCHEM 31743-09, CELCHEM 31744-09, and CELCHEM 31745-09. Other exemplary rheology modifiers include organic compounds such as EFKA RM1900 and EFKA RM1920, both modified hydrogenated castor oils from BASF. The colorant may be added together with a clay component. In an embodiment, the clay is CLAYTONE® HY from Southern Clay Products. In an embodiment the clay component may be replaced with a silica, e.g., AEROSIL 200 available from Degussa Canada, Ltd., and is added in an amount within the range of from about 1% to about 5% by weight, or from about 1.4% to about 3.5% by weight, or from about 1.8% to 2.0% by weight, based on the total weight of the composition.

Digital offset ink compositions of embodiments include initiator systems, which may include a photoinitiator that initiates polymerization of curable components of the ink, including the curable monomer. In an embodiment, the initiator is an ultraviolet radiation-activated photoinitiator. Exemplary photoinitiators include IRGACURE 379, IRGACURE 184 and IRGACURE 819, both available from Ciba Specialty Chemicals. IRGACURE 379 is 2-dimethylamino-2-(4-methyl-benzyl)-1-(4-morpholino-4-yl-phenyl)=butan-1-one, with a molecular weight of 380.5. IRGACURE 184 is 1-hydroxy-cyclohexyl-phenyl-ketone, having a molecular weight of 204.3. IRGACURE 819 is bis(2,4,6-trimethylbenzoyl)-phenylphosphine oxide, having a molecular weight of 418.5. Another exemplary photoinitiator is Esacure KIP 150, available from Lamberti Technologies, which is an oligomeric alpha hydroxyketone, oligo[2-hydroxy-2-methyl-1-[4-(1-methylvinyl)phenyl]propanone]. The photoinitiator(s) may be present in an amount of from 0 to about 10 wt % of the ink composition, including from about 5 to about 8 wt %.
Ink formulations based on the above-mentioned water-dilutable ink material components were formed. These inks were prepared by process familiar to those in the art. Exemplary formulations are disclosed in Table I, and do not limit the scope of disclosure. Table I: Digital advanced lithography imaging high Viscosity Ink set.

| **DALI High Viscosity Ink Set** | | | | | |
|---|---|---|---|---|---|
| **Components** | | **K-68** | **C-181** | **M-50** | **Y-17** |
| **Type** | **Used** | **%** | **%** | **%** | **%** |
| Pigment | | Mogul E Carbon Black | Irgalite Blue GLO | Permanent Rubine Red L5B01 | Permanent Yellow GMX |
| | | 16.25 | 17.50 | 15.00 | 17.50 |
| Dispersant | | Solsperse J200 | Solsperse 39000 | Solsperse J180 | Solsperse 32000 |
| | | 2.40 | 7.00 | 6.00 | 4.80 |
| Vehicle | CN294E | 64.24 | 60.73 | 54.43 | 52.91 |
| | CN2256 | 2.00 | 1.00 | 8.81 | 9.00 |
| | CD-501 | | 1.76 | 5.75 | 5.80 |
| Stabilizer | CN3216 | 0.10 | 1.00 | 1.00 | 1.00 |
| Photoinitiators | Irgacure 379 | 2.00 | 2.00 | 2.00 | 2.00 |
| | Irgacure 819 | 1.39 | 1.39 | 1.39 | 1.39 |
| | Esacure Kip 150 | 3.62 | 3.62 | 3.62 | 3.60 |
| Additives | Claytone HY | 8.00 | 4.00 | 2.00 | 2.00 |
| Total Amount | % | 100.00 | 100.00 | 100.00 | 100.00 |

The formulated ink (Table 1) set having has high viscosity (over 200,000 cps at 100 rad/sec at 35°C), suitable for printing in digital advance lithography imaging architectures. While Table 1 shows the use of three (3) photoinitiators; the use of four (4) photoinitiators can be used to facilitate the design of inks that have the same photoinitiator package and as may be required the same curing performance.

The formulated four inks (200, 300, 400, and 500) have viscosities within 5% of each other at 100 rad/sec and between 5 × 10⁵ and 1 × 10⁷ mPa·s at 1 rad/sec which is the estimated shear conditions at transfer to substrate (112 at FIG. 1).

The formulated high viscosity ink set will show no signs of phase separation after >1 month standing at room temperature.

The formulated high viscosity ink set displays an excellent transfer characteristic when printed in a digital advanced lithography imaging system test fixture.

It will be appreciated that various of the above-disclosed and other features and functions, or alternatives thereof, may be desirably combined into many other different systems or applications. Also that various presently unforeseen or unanticipated alternatives, modifications, variations or improvements therein may be subsequently made by those skilled in the art which are also intended to be encompassed by the following claims.

## Claims

1. An ink composition for variable data lithography printing comprising:
an ink vehicle and at least one colorant component suspended in solution in the ink composition; and
the solution comprising two or more of
at least one dispersant;
a thermal stabilizer; and
a photo initiator system having at least three or more photoinitiators being used at very specific ratios to each other;
wherein a viscosity of the ink composition for variable lithography printing, after addition of a high viscosity thickening agent component to the ink composition, is from about 1.05 to about 2 times higher than the viscosity before the addition of a high viscosity thickening agent to the ink composition.

2. The ink composition of claim 1, the solution further comprising:
a rheology modifying agent.

3. The ink composition of claim 2, wherein the vehicle is a radiation-curable compound that comprises monomer compounds selected from the group of compounds comprising mono-, di-, and tri-functional acrylate monomers, tetra-functional acrylates and oligomers.

4. The ink composition of claim 3, wherein the radiation-curable water-dilutable compound comprises functional acrylate compounds.

5. The ink composition of claim 3, wherein the at least one colorant component comprises a pigment, the pigment component is in a proportion of at least 15% by weight.

6. A process for variable lithographic printing, comprising:
applying a dampening fluid to an imaging member surface;
forming a latent image by evaporating the dampening fluid from selective locations on the imaging member surface to form hydrophobic non-image areas and hydrophilic image areas;
developing the latent image by applying an ink composition comprising an ink component to the hydrophilic image areas; and
transferring the developed latent image to a receiving substrate;
wherein the ink composition comprises an ink vehicle and at least one colorant component suspended in solution in the ink composition; and
the solution comprising two or more of
at least one dispersant;
a thermal stabilizer; and
a photo initiator system having at least three or more photoinitiators being used at very specific ratios to each other;
wherein a viscosity of the ink composition for variable lithography printing, after addition of a high viscosity thickening agent component to the ink composition, is from about 1.05 to about 2 times higher than the viscosity before the addition of a high viscosity thickening agent to the ink composition;
wherein colorant components s have viscosities within 5% of each other at 100 rad/sec and between 5 × 10⁵ and 1 × 10⁷ centipoise at 1 rad/sec.

7. The process for variable lithographic printing of claim 6, the solution further comprising:
a rheology modifying agent;
wherein the rheology modifying agent is present in the ink composition in a range of about 1 weight percent to about 10 weight percent.

8. The process for variable lithographic printing of claim 7, wherein the vehicle is a radiation-curable compound that comprises monomer compounds selected from the group of compounds comprising mono-, di-, and tri-functional acrylate monomers, tetra-functional acrylates and oligomers.

9. The process for variable lithographic printing of claim 8, wherein the radiation-curable water-dilutable compound comprises functional acrylate compounds.

10. The process for variable lithographic printing of claim 8, wherein the at least one colorant component comprises a pigment, the pigment component is in a proportion of at least 15% by weight.
